# EUROPEAN PATENT SPECIFICATION

(11) **EP 3 127 198 B1**
(45) Date of publication and mention of the grant of the patent: **22.04.2020**
(21) Application number: 15773479.9
(22) Date of filing: 30.03.2015
(51) Int. Cl.: H01S 3/098, H01S 3/16, H01S 3/08, H01S 3/109

(54) **MID-IR KERR LENS MODE LOCKED LASER WITH NORMAL INCIDENCE MOUNTING OF POLYCRYSTALLINE TM:II-VI MATERIALS AND METHOD FOR CONTROLLING PARAMETERS OF POLYCRYSTALLINE TM:II-VI KERR LENS MODE LOCKED LASER**
MID-IR-KERRLINSENMODENGEKOPPELTER LASER MIT SENKRECHTEINFALL-MONTAGE VON POLYKRISTALLINEN TM:II-VI-MATERIALIEN UND VERFAHREN ZUR STEUERUNG DER PARAMETER EINES POLYKRISTALLINEN TM:II-VI-KERRLINSENMODUSGEKOPPELTEN LASERS
LASER À MODES BLOQUÉS À LENTILLE DE KERR EN IR MOYEN AVEC MONTAGE EN INCIDENCE NORMALE DE MATÉRIAUX TM:II-VI POLYCRISTALLINS ET PROCÉDÉ DE RÉGULATION DES PARAMÈTRES D'UN LASER À MODES BLOQUÉS À LENTILLE DE KERR AVEC TM:II-VI POLYCRISTALLINS

(30) Priority: 01.04.2014 US 201461973616 P
(43) Date of publication of application: 08.02.2017
(73) Proprietor: IPG Photonics Corporation, Oxford, Massachusetts 01540 (US)
(72) Inventor: VASILYEV, Sergey, Oxford, MA 01540 (US); MIROV, Michael, Oxford, MA 01540 (US); MOSKALEV, Igor, Oxford, MA 01540 (US)
(74) Representative: Kobiako von Gamm, Iouri
(86) International application number: PCT/US2015/023232
(87) International publication number: WO 2015/153391

(56) References cited:
- WO-A1-2015/047788
- US-A1- 2009 237 661
- US-A1- 2010 103 960
- US-A1- 2012 250 719
- US-A1- 2012 327 959
- US-A1- 2013 135 711
- HUANG X G ET AL: "Analytical design for Kerr-lens mode locking of compact solid-state lasers", OPTICS COMMUNICATIONS, ELSEVIER, AMSTERDAM, NL, vol. 158, no. 1-6, 15 December 1998 (1998-12-15), pages 322-330, XP004150786, ISSN: 0030-4018, DOI: 10.1016/S0030-4018(98)00551-3
- SERGEY VASILYEV ET AL: "Kerr-lens mode-locked femtosecond polycrystalline Cr^2+:ZnS and Cr^2+:ZnSe lasers", OPTICS EXPRESS, vol. 22, no. 5, 26 February 2014 (2014-02-26), page 5118, XP055363534, DOI: 10.1364/OE.22.005118
- EVEGENI SOROKIN ET AL: "Femtosecond operation and random quasi-phase-matched self-doubling of ceramic Cr:ZnSe laser", CONFERENCE ON LASERS AND ELECTRO-OPTICS (CLEO) AND QUANTUM ELECTRONICS AND LASER SCIENCE CONFERENCE (QELS), 2010 : 16 - 21 MAY 2010, SAN JOSE, CA, USA, IEEE, PISCATAWAY, NJ , USA, 16 May 2010 (2010-05-16), pages 1-2, XP031700474, ISBN: 978-1-55752-890-2
- MIROV SERGEY B ET AL: "Progress in Mid-IR Lasers Based on Cr and Fe-Doped II-VI Chalcogen", IEEE JOURNAL OF SELECTED TOPICS IN QUANTUM ELECTRONICS, IEEE SERVICE CENTER, PISCATAWAY, NJ, US, vol. 21, no. 1, 1 January 2015 (2015-01-01), pages 1-19, XP011558375, ISSN: 1077-260X, DOI: 10.1109/JSTQE.2014.2346512 [retrieved on 2014-09-10]

## Description

### SUMMARY OF THE DISCLOSURE

### Field of the disclosure

This disclosure relates to mid-IR solid state self-starting Kerr lens mode-lock lasers. Particularly, the disclosure relates to a Kerr lens mode-lock laser operative to emit picosecond and femtosecond pulses over a 1.8 - 8 µm spectral range and configured with a normally cut gain medium which is selected from II-VI group of polycrystalline materials doped with transition metal ions.

### Prior art

In the article "Analytical design for Kerr-lens mode locking of compact solid-state lasers" (OPTICS COMMUNICATIONS, vol. 158, no. 1-6, 15 December 1998 (1998-12-15), pages 322-330) of Huang X G et al. an analytical solution for soft-aperturing Kerr-lens mode locking (KLM) of compact non-astigmatic three-element resonators is derived using non-linear ABCD ray matrix method.
In the article "Kerr-lens mode-locked femtosecond polycrystalline Cr"2+:ZnS and Cr"2+:ZnSe lasers" (OPTICS EXPRESS, vol. 22, no. 5, 26 February 2014 (2014-02-26), page 5118) of Sergey Vasilyev et al. a Kerr-lens mode-locked polycrystalline Cr2+:ZnS and Cr2+:ZnSe lasers, with pulse duration of 125 fs at a pulse repetition rate of 160 MHz, emitting around 2,3 - 2,4 µm is disclosed.
However, these articles do not address problems associated with relatively poor thermal-optical properties and non-linear effects in the gain medium associated with effects like a so-called non-uniformity.
Pulsed lasers are used for applications in various fields, such as optical signal processing, laser surgery, bio-medicine, optical diagnostics, two-photon microscopy, optical probing, optical reflectometry, material processing, etc. There are three main classes of pulsed lasers, namely Q-switched lasers, gain switched lasers, and mode-locked lasers with the latter being of a particular interest for this disclosure.

The mode-locked laser has multiple longitudinal modes that oscillate simultaneously with their respective phases locked to one another which allows generating of uniformly spaced short and ultra-short pulses. The fixed phase relationship is established by a mode-locking mechanism capable of synchronizing the phases of the lasing modes so that the phase differences among all lasing modes remain constant. These optically phase-locked modes then interfere with each other to form short optical pulses.

Kerr-lens method (Kerr- focusing, self- focusing), further referred to as Kerr-Lens Mode-locking (KLM), is one of the ultra-fast mode-locking mechanisms based on the phenomenon intrinsic to materials of groups II to VI and other optical materials, e.g. Ti-S) which are doped with transition metal ions. The KLM is a mechanism in which a pulse that builds up in a laser cavity containing a gain medium and a Kerr medium experiences not only self-phase modulation, but also self-focusing. While the KLM is not a saturable absorber, the non-linear optical properties such as the Kerr effect, give an artificial "saturable absorber" effect, which has a response time much faster than any intrinsic saturable absorber.

Typically, the gain medium used in the KLM-based lasers includes titanium sapphire Ti:S which has exceptionally good thermal-optical properties. As known, the simplicity and advantages of the resonator with Brewster mounted gain medium, such as Ti:S greatly, overweight the disadvantages associated with its mounting.

In contrast to the standard Ti:S single crystalline medium, transition metal (TM) doped II-VI materials in the form of single and particularly polycrystals offer unique opportunities for generation of ultra-short laser pulses in the mid-IR range (2 - 8 µm) which is complementary to Ti-S coverage (0.7-1.1 µm). Nonlimiting examples of suitable crystalline materials operating in a mid-IR wavelength range may include Zink Selenide ("ZnSe"), Zinc sulfide ("ZnS"), CdZnSe, CdZnTe and many others that demonstrate a bandwidth selectively covering the 1.8 - 8 micron spectral range.

Due to various reasons, those materials have poor thermal optical properties and feature a very strong non-uniformity of the thermal-optical effects when placed in Brewster configuration. As a result, the output power of the TM:II-VI lasers with Brewster mounting does not exceed a few Watts. Furthermore, the efficiency of such a laser is limited due to necessity to use relatively thin gain element with relatively low pump absorption.

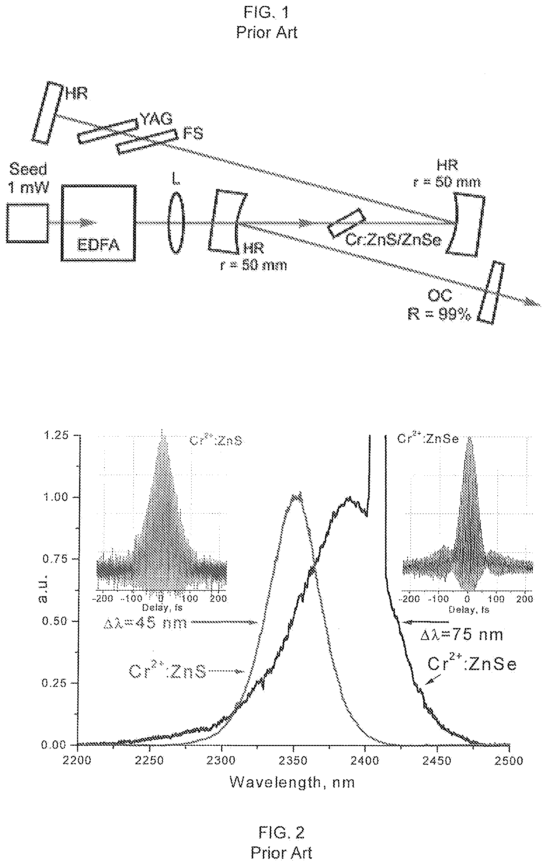

FIG. 1 shows a working example of one of possible schematics of polycrystalline Cr²⁺:ZnSe/ZnS KLM laser. The output of a linearly polarized Er- doped fiber amplifier (EDFA), seeded by a low noise 1550 nm narrowband semiconductor laser, is coupled to the standard astigmatism compensated asymmetric Z-folded resonator consisting of two curved high reflecting (HR) mirrors, plane HR mirror and plane output coupler (OC, R=99%). Astigmatism means that the beam foci for sagittal (the plane perpendicular to the main plain of the cavity) and tangential (i.e., parallel to the main plane) planes are not at the same position. Also, the stability regions of the cavity are different for different planes and the output is elliptical. These phenomena require compensation.

In the device of FIG. 1, the length of the laser cavity is about 94 cm. The KLM regime is obtained using two types of the laser (gain) medium: polycrystalline Cr²⁺:ZnS (2.0 mm thick, 43% low-signal transmission at 1550 nm) and polycrystalline Cr²⁺:ZnSe (2.4 mm thick, 15% transmission). Gain elements are plane-parallel polished, uncoated and Brewster mounted on a copper heat sink without forced cooling. In order for an optical cavity to sustain a pulse, the temporal shape and duration of the pulse must remain stable as it circulates through the cavity. As a result, the pulse is deformed, as it passes through them due to the wavelength dependence of the refractive index, and needs to be compensated. While the cavity mirrors used in the shown configuration are non-dispersive, the gain medium and other optional components are. The dispersion compensation is implemented using a combination of Brewster mounted fused silica plate (2 mm thick) and YAG plate (4 mm thick). The group delay dispersion of the resonator at 2400 nm, near the central laser wavelength, is about -1000 fs².

The laser is optimized for a maximum CW output power and then the distance between the curved mirrors is fine-adjusted in order to obtain a KLM regime. The mode-locked laser oscillation is initiated by the OC translation.

Multi-hour uninterrupted single-pulse oscillations are observed in Cr²⁺:ZnSe at 1 W pump power and 60 mW laser output power. Further increase of the pump power results in multi-pulsing and frequent interruptions of the mode-lock. Maximum stability of Cr²⁺:ZnS KLM laser is reached at 1.25 W pumping and 30 mW output power (1-2 hours of uninterrupted single-pulse oscillations).

FIG. 2 compares the emission spectra and autocorrelation traces obtained for Cr²⁺:ZnS and Cr²⁺:ZnSe lasers in the KLM regime. The measurements were carried out for single pulse oscillations at 160 MHz pulse repetition rate. The output of Cr²⁺:ZnS laser is sech² transform limited: 125 fs pulse duration was derived from the autocorrelation trace assuming sech² profile and 126 fs pulse duration was calculated from the emission spectrum assuming ΔτΔv = 0.315 time-bandwidth product. On the other hand, the shape of the autocorrelation trace for Cr²⁺:ZnSe laser reveals chirped pulses. Emission spectrum of the laser is distorted and, hence, the time-bandwidth product is increased. Roughly, the pulse duration of Cr²⁺:ZnSe laser is estimated to be within a 100 - 130 fs range.

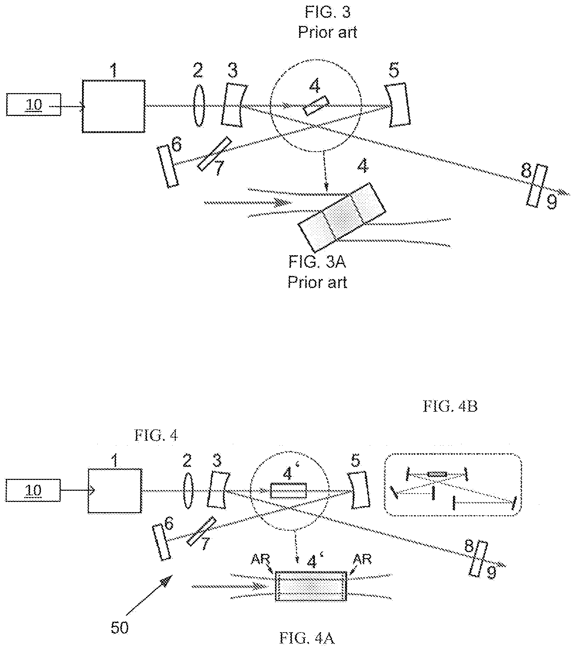

FIG. 3 illustrates a rather simplified cavity design of the known KLM laser. Specifically, an optical pump source 1, pumped by a seed laser 10, emits the pump beam (shown in green) which is focused and shaped while propagating through a system of pump beam focusing and shaping optics 2, which may include lenses or mirrors. The focused and shaped beam is then coupled into the optical cavity through a folded concave dielectric coated mirror 3 with high reflectivity at a laser wavelength and high transmission at a pump wavelength. After propagating further through a gain medium 4, a laser beam (shown in red) at the desired wavelength impinges on a folded concave dielectric coated mirror 5 with high reflectivity at the laser wavelength and optional high transmission at the pump wavelength. Reflected from mirror 5, the laser beam is incident on a plane mirror 6 with high reflectivity at the laser wavelength which is dielectric or metal coated. Optionally, a dispersion compensation component 7, such as a plane parallel plate mounted in the laser resonator at Brewster's angle, is located in the cavity arm between mirrors 5 and 6. After retro-reflection from mirror 6, the laser beam is incident on mirror 5 and propagates through gain medium 4 to impinge on mirror 3. Finally, the laser beam decouples from the cavity through an output coupler ("OC") 8 as an output beam 9. Path of the laser beam is shown in red while the pump beam is in green.

The Brewster mounting of the gain medium, as shown in FIGs. 1 and 3, is overwhelmingly used in the KLM lasers due to its several advantages. First, at the Brewster's angle of incidence, light with a particular p-polarization is perfectly transmitted through a surface with no reflection which thus makes special and expensive antireflection coatings unnecessary. Second, the gain medium functions as a polarizer which makes the use of additional polarizers unnecessary. Third, the Brewster mounting of the gain element and special choice of the resonator's parameters allows compensating the astigmatism of the laser beam, which propagates within the resonator, and of the output laser beam (astigmatism is caused by non-normal incidence of light on curved mirror surfaces). The astigmatism of the resonator may reduce performance of the laser (e.g. the quality of the output laser beam). In some delicate situations, such as Kerr-lens mode locking, the astigmatism may even impede the proper laser operation.

The Brewster mounting of the gain medium is not, however, without disadvantages. As illustrated in in FIG. 3A, the Brewster mounting scheme includes strong non-uniformity of the laser and pump beams inside the gain element. The optical beam is being expanded in one direction and keeps the original size in a perpendicular direction. The beam expansion factor inside the Brewster mounted optical material equals the refraction index of the material n. Thus, the Brewster mounting (i) results in decrease of the optical intensity inside the gain element by a factor of *n,* and (ii) in the asymmetry of the pump and laser beams results in non-uniform heat release inside the pumped channel and hence in non-uniformity of various thermal-optical effects in the material.

The disadvantages of the Brewster mounting limit the output power of about 1 W in the single crystalline TM:II-VI materials. The KLM laser operation with the output power of 30-60 mW has been recently demonstrated in polycrystalline material, but clearly needs to be increased to meet the needs required by many industrial and scientific applications. However, further power scaling of KLM TM:II-VI lasers with a conventional scheme of the resonator represents a challenging problem. In addition, the above-disclosed disadvantages prevent shortening the pulse duration. Yet again, many applications require pulses shorter than those currently available with the currently reported record short pulse of about 40 femtosecond in the desired range of frequencies.

In principle, the optical density of Brewster mounted gain medium limits a pump power and therefore the output power. As the thickness of the gain medium increases, which allows the use of higher pump powers, so does the degree of astigmatism which is necessarily should be compensated. Otherwise, as mentioned above, the KLM-based lasers are highly sensitive to the astigmatism phenomenon and, in the worst possible scenario, may stop properly operating. However such compensation is neither easy nor particularly effective.

A need, therefore, exists for a high power mid-IR solid state self-starting Kerr lens mode-locked laser with an optical cavity which includes a polycrystalline nonlinear material selected from transition metal (TM) doped II-VI materials and mounted at a normal angle in the resonator cavity so as to significantly improve of the laser output power, efficiency and pulse duration in the KLM regime.

A further need, thus, exists for the above disclosed mid-IR KLM lasers which has a configuration capable of operating at high pump powers so as to output high power ultra-short pulses of up to several tens of watts.

### SUMMARY OF THE INVENTION

The above articulated needs are satisfied by the disclosed Kerr lens mode locked laser as defined in claim 1 and by a method of femtosecond laser emission in a Kerr lens modelocked laser as defined in claim 12. The laser is configured with a gain medium, such as TM doped II-VI materials, which is mounted in the optical cavity at normal incidence to a pump beam. The normal incidence mounting has the following important features and advantages:
The laser and pump beams remain circular throughout the gain medium;
The heat release inside the pumped channel and, hence, various thermal-optical effects in the material are uniform and axially symmetric;
The optical intensity inside the gain element is increased by a factor of n (if compared with conventional Brewster mounting scheme);
Various nonlinear optical effects inside the gain element are increased due to higher optical intensity;
More pronounced nonlinear effects are of importance in KLM laser regime as the Kerr effect has nonlinear nature;
More pronounced nonlinear Kerr effect in TM:II-VI medium may allow for the compensation (at least partial) of the astigmatism of the resonator. Thus, the use of TM:II-VI gain elements at normal incidence allow relaxing (to some extent) the requirements to the compensation of astigmatism in the resonator of KLM laser.
Normal incidence mounting greatly simplifies the use of the gain elements with large length and hence high pump absorption;
High pump absorption and high optical intensity result in more efficient laser interaction and hence enable flexibility in the selection of the output coupler parameters to allow for increased laser output powers (at a given pump power);
Uniform thermal-optical effects in the material enable the increase of the pump power (if compared with conventional Brewster mounting scheme) and, hence, allow for further scaling up the laser output power.

All of the above are of special importance for TM:II-VI laser medium due to a relatively poor thermal optical properties of these materials and to TM:II-VI-based lasers operating in KLM regime.

The inventive concept is realized in two embodiment. Each of the embodiments includes a few aspect as briefly disclosed immediately below.

In accordance with the first aspect of the first embodiment, the inventive Kerr Mode Locked ("KLM") laser is configured with a resonant cavity, and a gain medium selected from polycrystalline transition metal doped II-V1 materials ("TM:II-VI). The gain medium is at a normal angle of incidence and mounted in the resonant cavity so as to induce Kerr-lens mode locking sufficient for the resonant cavity to emit a pulsed laser beam at a fundamental wavelength. The pulses of the emitted laser beam at the fundamental wavelength each vary within a 1.8 - 8 micron ("µm") wavelength range, have a pulse duration equal to or longer than 30 - 35 femtosecond ("fs") time range and an average output power within a mW to about 20 watts ("W") power range.
The KLM according to the present invention further includes a linearly polarized fiber laser pump source. The latter is selected from an erbium or thulium doped single mode fiber and operative to emit a pump beam which is coupled into the gain medium at a pump wavelength different from the fundamental wavelength. The laser and pump beams remain circular while propagating through the gain medium.

In accordance with the second aspect, the KLM laser of the first aspect is configured with the gain medium having a phase-matching bandwidth broad enough to provide for emitting the output laser beam at half the fundamental wavelength (SHG) within the entire fundamental wavelength range.

In accordance with the third aspect, the inventive KLM laser of the first and/or second aspects has the gain medium configured with the phase-matching bandwidth which is sufficiently broad to generate second, third and fourth harmonics waves of the fundamental wavelength simultaneously as the pump beam propagates through the gain medium.

In accordance with the fourth aspect, any combination of first, second and third aspects or of each of these individually, the inventive KLM laser further includes a planar resonant cavity.

In accordance with the fifth aspect of the disclosure, any combination of first, second, third and fourth aspects or of any of these individually, the gain medium includes TM doped binary and ternary II-VI materials.

In accordance with the sixth aspect of the disclosure, the inventive KLM laser of each of the above five aspects or any combination of these aspects, the gain medium is selected from the group consisting of Cr2+:ZnSe, Cr2+:ZnS, Cr2+:CdSe, Cr2+:CdS, Cr2+:ZnTe, Cr2+:CdMnTe, Cr2+:CdZnTe, Cr2+:ZnSSe, Fe2+:ZnSe, Fe2+:ZnS, Fe2+:CdSe, Fe2+:CdS, Fe2+:ZnTe, Fe2+:CdMnTe, Fe2+:CdZnTe, and Fe2+:ZnSSe and a combination of these.

In the eighth aspect, the disclosed laser KLM laser of each of first through seventh or any combinations of these aspects includes the gain medium configured to uniformly release heat in response to the coupled pump beam. The latter generates uniform, axially symmetric thermal-optical effects inside the pumped gain medium.

In accordance with the ninth aspect of the disclosure, the inventive KLM of each of the previously eight aspects or any combination of these aspects includes the gain medium with the bandwidth. The bandwidth is sufficiently broad for generating the output laser beam at a sum of the pump and fundamental wavelengths and/or a difference therebetween, and/or a sum of fundamental and second, third and/or fourth optical harmonics of the fundamental frequency.

According to the twelfth aspect, the KLM as disclosed in any of aspects is configured with a resonant cavity defined by at least two adjacent upstream and downstream dielectrically coated folded mirrors which are spaced from one another along a path of the pump beam and flank the gain medium. Each mirror is configured with a high reflectivity at the fundamental wavelength and high transmission at the pump wavelength, with the downstream folded mirror being configured to at least partially transmit the high harmonic wave.

According to the thirteenth aspect of the disclosure, the KLM laser, as disclosed in each of the previously disclosed aspects or any combination of these aspects, has the resonant cavity . including a partially transmitting at the fundamental wavelength output coupler, and at least one plane dichroic mirror upstream from the output coupler. The cavity further has at least one intermediary plate with high transmission at the fundamental and high harmonic waves.

In the fourteenth aspect of the disclosure, the KLM of each of the previous aspects or any combination of these is formed with the resonant cavity which includes a dispersion compensation element configured as a plane parallel plate or prism and operative to limit a dispersion. The compensation element is mounted at a Brewster angle.

In the fifteens aspect of the disclosure, the KLM of each of the previous aspects or any combination of these is formed with the resonant cavity which includes a Brewster mounted birefringent tuner.

In the sixteenth aspect of the disclosure, the KLM of each of the previous aspects or any combination of these further includes a translation stage displacing the gain medium within the resonant cavity along a waist of the laser beam. The displacement of the gain medium is controlled to redistribute the average power of the laser beam among a primary output of the emitted laser beam at the fundamental wavelength and secondary outputs at respective second, third and fourth harmonic waves.

In accordance with second embodiment of the disclosure, its first aspect describes a method for nonlinear frequency conversion of femtosecond laser emission in the Kerr lens-mode ("KLM") locked laser, as disclosed in any of or any combination of all previous aspects of the first embodiment. The method provides for a multi-pass resonant cavity and includes mounting a gain medium which is selected selected from transition metal doped II-VI ("TM:II-VI") materials. The latter are cut at a normal incidence angle within the resonant cavity. The Kerr-lens mode locks the resonant cavity so as to emit a primary output of the laser emission including a train of output pulses at a fundamental wavelength. The pulses each each vary within a 1.8 - 8 micron ("µm") wavelength range, have a pulse duration equal to or longer than 30 - 35 femtosecond ("fs") time range and an average output power within a mW to about 20 watts ("W") power range.

In the second aspect of the method, the resonant cavity is further provided with a secondary output simultaneously with the primary output. The secondary output is at a half-wavelength of the fundamental wavelength.

In the third aspect of the second embodiment, the method of first and/or second aspects provides additional outputs of the laser beam at third and fourth harmonics of the fundamental wavelength simultaneously with the primary and secondary outputs.

In the fourth aspect of second embodiment, the method of any of the previous aspects or any combination thereof includes generating a pump beam at a pump wavelength different from the fundamental wavelength, and coupling the pump beam into the gain medium and generating outputs of the laser beam at a sum of the pump and fundamental wavelengths and a difference therebetween, and a sum of fundamental and second, third and fourth optical harmonic wavelengths and a difference thereof.

### BRIEF DESCRIPTION OF THE DRAWINGS

The above and other aspects, features and advantages of the disclosure will become more readily apparent from the following drawings, in which:
FIG. 1 is one exemplary schematic of the known prior art KLM laser;
FIG. 2 is emission spectra and autocorrelation traces for the KLM laser of FIG. 1.
FIG. 3 is another exemplary schematic of the known art KLM laser;
FIG. 3A is the enlarged detail of FIG. 3 illustrating beam propagation in a Brewster mounted gain medium;
FIG. 4 is an optical schematic of one design of the inventive KLM resonator;
FIG. 4A is the enlarged gain medium of FIG. 2;
FIG. 4B is one of possible schematics of the disclosed KLM laser of FIG. 4;
FIG. 5 is a measured laser emission spectrum of the disclosed KLM laser fitted with a theoretical curve for transform limited laser emission spectrum.
FIG. 5A is an autocorrelation trace;
FIG. 5B is the image of the output laser beam emitted by the disclosed KLM laser;
FIG. 6 is an optical schematic of the optimized inventive KLM laser;
FIG. 7 illustrates measured emission spectra of the disclosed KLM laser of FIG. 6 configured with the laser's output coupler having respective different reflectivity;
FIG. 8 illustrates autocorrelation traces of the KLM laser of FIG. 6 corresponding to respective emission spectra of FIG. 7;
FIG. 9 is an enlarged view of the polycrystalline transition metal ("TM) TM:II-IV gain medium of the disclosed KLM laser;
FIG.10 is still another optical schematic of the inventive KLM laser;
FIGs. 11A are four images of the laser's output beam at respective fundamental, second, third and fourth harmonic wavelengths;
FIG. 11B are spatial profiles of the output of the inventive KLM laser at a fundamental wavelength and second harmonic acquired by a pyrocamera;
FIG. 11C is a waveform of the KLM laser pulse train acquired at the second harmonic wavelength.
FIG. 12 is a further optical schematic of the inventive KLM laser provided with a means for controlling laser's parameters;
FIG. 12A is the enlarged view of the gain medium of FIG. 12;
FIG. 13, 13A and 13B illustrates the controllable generation of 68 fs and 84 fs pulses by the inventive KLM laser; and
FIG. 14 illustrates the controllable generation of 46 fs pulse by the inventive KLM laser.

### SPECIFIC DESCRIPTION

Reference will now be made in detail to embodiments of the invention. Wherever possible, same or similar numerals are used in the drawings and the description to refer to the same or like parts or steps common to the prior art and inventive configurations. The drawings are in simplified form and are not to precise scale. Unless specifically noted, it is intended that the words and phrases in the specification and claims be given the ordinary and accustomed meaning to those of ordinary skill in the diode and liber laser arts. The word "couple" and similar terms do not necessarily denote direct and immediate connections, but also include mechanical and optical connections through free space or intermediate elements.

FIG. 4 illustrates the exemplary configuration of the disclosed KLM laser 50 having gain medium 4' mounted at normal incidence to the plane of beam propagation in the shown resonator. The remaining components are similar to those of FIG. 3 and include optical pump source 1 seeded by source 10 and emitting a pump beam (shown in green). The pump source 1 may be configured as a standard linearly polarized single transverse mode ("SM") Er-doped fiber laser (EDFL). Alternatively, source 10 may be based on a thulium ("Tm")-doped SM fiber laser.

The normal incidence mounting of gain medium 4' is critical to achieving higher output laser powers and efficiency. In particular, polycrystalline antireflection coated gain element 4' is coupled between folded concave dielectric-coated mirrors 3 and 5. While gain element 4' is shown to be plane parallel, it can also be wedged. The mirror 3 is highly reflective at the laser wavelength and highly transmissive at the pump wavelength, whereas mirror 5 is configured with high reflectivity at the laser wavelength and optional high transmission at the pump wavelength. The resonator may have a variety of configurations. For example, FIG. 4B illustrates the resonator with more than two folding mirrors as shown. Regardless of the resonator configuration, eventually the laser beam impinges on output coupler ("OC") 8 and is coupled out of the resonator as output beam 9 at the laser wavelength.

It should be mentioned that the dispersion compensation can be implemented using specially optimized "dispersive" mirrors. A highly reflective mirror may be a viable alternative to output coupler 8. The resonator may include additional components for the laser wavelength tuning.

Unlike the conventional resonator of the KLM laser of FIGs. 1 and 3, the inventive planar resonator has astigmatism. However, in a particular situation of TM:II-VI laser materials, the high uniformity of the pump and laser beams inside the gain element, as shown in FIG. 4B, allow the gain element to substantially compensate for astigmatism of the resonant cavity. The principle experiment, which is described below, confirms that statement. Furthermore, the astigmatism of the disclosed planar resonator can be kept even lower by careful choice of the radii of curvature of the folded concave mirrors and of the folding angles. If necessary, there are also a number of techniques for astigmatism compensation in a folded resonator without a Brewster optical element well known to one of ordinary skill in the laser arts, but all of them are simply optional and not necessary as in the known prior art devices.

Accordingly, a well-pronounced nonlinear Kerr effect in TM:II-VI medium may allow for a significant compensation of the astigmatism of the resonator. Thus, the use of TM:II-VI gain elements at normal incidence allows for somewhat relaxed requirements to the compensation of astigmatism in the resonator of KLM laser 50.

Main advantages of the normal incidence mounting of the gain element are (i) better management of the thermal optical effects in the gain element due to circularity of the pump and laser beams, (ii) significant increase of pump and laser intensity inside the gain element (if compared with the standard Brewster mounting), (iii) greater simplicity of use of the gain elements with large length and volume and hence high pump absorption. The normal incidence mounting could be also more favorable for Kerr-lens mode-locking.

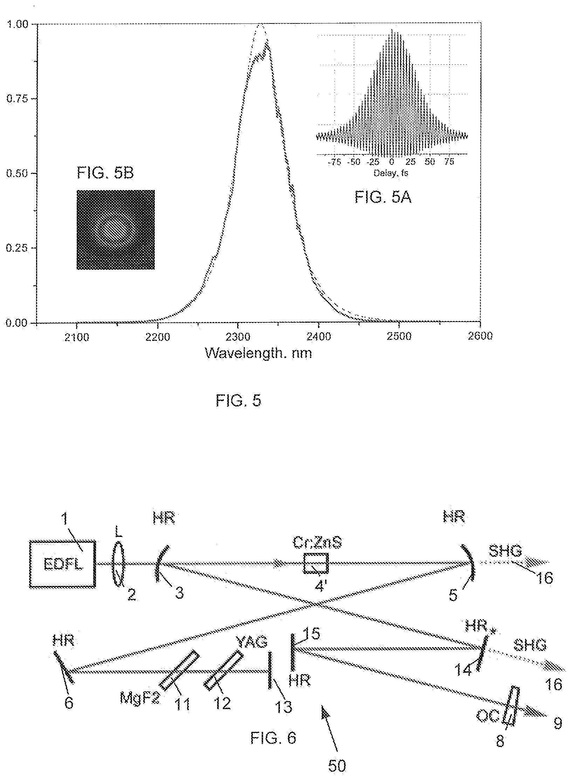

FIGs. 5 - 5B illustrate the results of KLM laser planar resonator 50 of FIG. 4 configured with standard mass-produced AR coated polycrystalline Cr:ZnS gain element 4. The KLM regime of the laser has been easily obtained. The KLM regime of the laser was confirmed by measurement of the laser emission spectrum of FIG. 5 and of the nonlinear autocorrelation function of FIG. 5A, as discussed herein below. The Fourier transform limited pulses with 84 fs pulse duration were confirmed by mathematical analysis of the experimental data, also discussed herein below. The transform-limited pulse is a theoretically shortest possible pulse determined as ΔtΔώ=1/2, where t is a pulse duration and Δώ - spectral width. As can be seen from the above, in order to generate the shortest possible light pulsed with a specific duration, a broad spectral bandwidth is required. As can be seen, the tested KLM TM:II-VI laser 50 was operative to output beam 9 at the fundamental/laser wavelength with an output power of about 1.3 W at 93 MHz repletion rate and pulse energy 14 nJ and featured transformed limited pulses and good beam quality, as shown in FIG. 5B. The obtained output power is believed to be uniquely high.

FIG. 6 illustrates inventive KLM laser 50 based on Cr²⁺:ZnS gain element 4 and having the optimized resonator. HR - dispersive high reflectors (GDD ∼-200 fs²), YAG - 2 mm thick Brewster mounted dispersion compensation plate, OC - output coupler (|GDD| < 150 fs²), MgF₂ - optional 0.5 mm thick Brewster mounted birefringent tuner (Lyot filter), L - pump focusing lens. SHG - secondary outputs of the laser at second harmonic wavelength. The laser is pumped at 1567 nm by a linearly polarized radiation of Er- doped fiber laser (EDFL).

The pump source 1 includes a standard linearly polarized Er- doped fiber laser (EDFL). In order to increase the laser output power, a 5 mm long polycrystalline Cr²⁺:ZnS gain element 4' with 11% low-signal transmission at 1567 nm pump wavelength is inserted between AR coated folded mirrors 3 and 5 at normal incidence on a water cooled copper heat sink. The lengths of the cavity legs were unequal with 3 to 5 ratio. Overall dispersion of the resonator at the maximum of laser emission (2300-2400 nm) was about 1400 - 1600 fs². For the experiments on wavelength tuning of the KLM laser a 0.5 mm thick Brewster-mounted birefringent tuner 11 (single-plate Lyot filter) made of MgF₂ was used. Additionally, a 2 mm thick Brewster mounted YAG plate 12 was placed next to tuner 11 in the leg defined between mirrors 6 and 13. The planar resonator further includes an additional leg defined between plain mirrors 15 and 14 immediately upstream from OC 8. Dispersion of the OCs is within ±150 fs² in 2200 - 2400 nm range. The outputs 16 at SHG are shown in blue, pump beam is in green, and laser beam is shown in red.

The KLM regime of the laser with the optimized planar resonator has been obtained using the output couplers with 96, 90, 70, and 50% reflectivity. Most measurements were carried out at the pulse repetition rate of 94.5 MHz. However, KLM laser oscillations were obtained in a range of the pulse repetition rates (80 - 120 MHz). Results of the laser characterization are summarized in the following table.

**Table**

| R_{OC}, | Pₒᵤₜ, | τ, fs | Δλ, | λ_{C}, | Pₚᵤₘₚ, |
|---|---|---|---|---|---|
| 96 | 0.3 | 85 | 70 | 2380 | 3.4 |
| 90 | 0.6 | 46 | 120 | 2300 | 5.2 |
| 70 | 1.2 | 68 | 84 | 2332 | 6.7 |
| 50 | 2.0 | 67 | 82 | 2295 | 10.0 |

| | | | | | |
|---|---|---|---|---|---|
| R_{OC} - reflectivity of the output coupler, Pₒᵤₜ - average output laser power in KLM regime, τ - laser pulse duration (FWHM), Δλ - width of the laser emission spectrum (FWHM), λ_{C} - laser emission peak, Pₚᵤₘₚ - optimal pump power | | | | | |

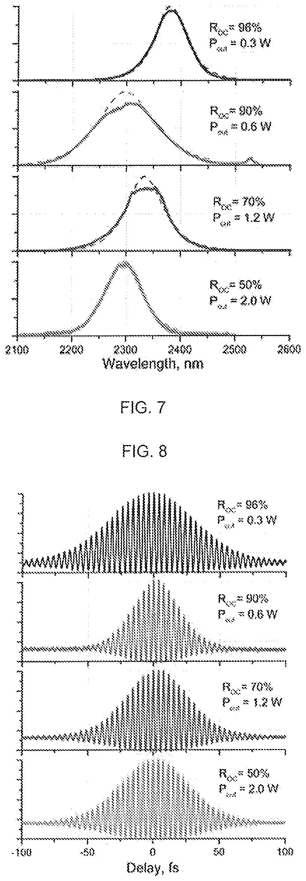

Emission spectra and autocorrelation traces of KLM laser 50 of FIG. 6 obtained for the OCs with different reflectivity are illustrated in FIGs. 7 and 8, respectively. The shape of the spectra and of the autocorrelation functions correspond to sech² pulses for all four types of the OC. This allows the use of the time bandwidth product of 0.315 for estimation of the pulse duration. The small peak in the spectrum measured at R_{OC} = 90% (2525 nm) indicates a presence of Kelly sidebands in the laser emission. The opposite sideband is suppressed due to a leakage through high reflectors at the wavelengths below 2200 nm. The flat-top spectra measured at R_{OC} = 90 and 70% for the case when a second harmonic generation (SHG) was directly obtained in polycrystalline Cr²⁺:ZnS are explained below.

Summarizing the above disclosed configurations of KLM laser 50 based on normally mounted polycrystalline II-VI materials and particularly polycrystalline Cr²⁺:ZnS laser, stable single-pulse fs laser oscillations are routinely obtained in a range of the pulse repetition rates 80 - 120 MHz with output power of fs laser of about 2 W, and shortest pulse duration about 46 fs. All of the above data is believed unprecedented for the II-VI gain medium. Furthermore, at several occasions, KLM laser 50 was operative to generate even more unique data with the output power of up to 20 W and the pulse duration as low as 30-35 picoseconds.

The practical applications of femtosecond lasers often require the nonlinear frequency conversion (e.g. optical harmonic generation, sum and difference frequency generation, and optical parametric generation. For instance, the 1.1 - 1.5 µm spectral range, which is of importance for multi-photon imaging, can be addressed using Ti:S fs laser combined with the optical parametric generator. The same spectral range can be addressed using SHG of TM:II-VI mid-IR fs laser operating in 2.2 - 3.0 µm spectral range.

Efficiency of SHG in nonlinear materials is limited by dispersion (a difference in velocity of light propagation at a fundamental laser wavelength and half the fundamental ("SH") wavelengths. Therefore, the energy transfer from the fundamental wavelength to the SH wavelength occurs at a limited length of the nonlinear material, so called coherence length ("CL"). In most materials CL is of the order of few tens of µm resulting in weak SH generation efficiency. A number of techniques to overcome this limit have been developed during past decades. Traditional techniques are based on birefringence of some nonlinear crystals. More recent developments are based on engineering of the microscopic structure of the nonlinear material (quasi phase matching or QPM). Standard QPM crystals contain regular patterns, optimized for the most efficient nonlinear frequency conversion at the desired laser wavelength, e.g. they have limited bandwidth of the nonlinear frequency conversion. More sophisticated patterning allows for an increase of the bandwidth, which is accompanied by a decrease of the overall conversion efficiency.

Polycrystalline TM:II-VI materials used here consist of microscopic single-crystal grains. The polycrystalline TM:II-VI samples used in the experiments have a grain size of the order of the coherence length of SHG process in middle IR wavelength range (30-60 µm, depending on the wavelength and type of the material). Thus polycrystalline TM:II-VI materials can be patterned like standard QPM material. Unlike in the standard QPM material, the patterning is not perfect but randomized (there are dissimilarities in the grain size and in orientation of the crystallographic axes). This randomization of the patterning results in low nonlinear gain (if compared with standard QPM material). However the randomization allows for SHG in very broad spectral range. Thus, polycrystalline TM:II-VI materials have very large bandwidth of the nonlinear frequency conversion. Efficiency of the nonlinear frequency conversion strongly depends of the optical intensity (for instance, SHG efficiency is proportional to squared optical intensity). Therefore, relatively low nonlinear gain of polycrystalline TM:II-VI material can be compensated by a very high intensity of fs laser pulses. Described properties of polycrystalline TM:II-VI materials are of importance for nonlinear frequency conversion of fs laser emission.

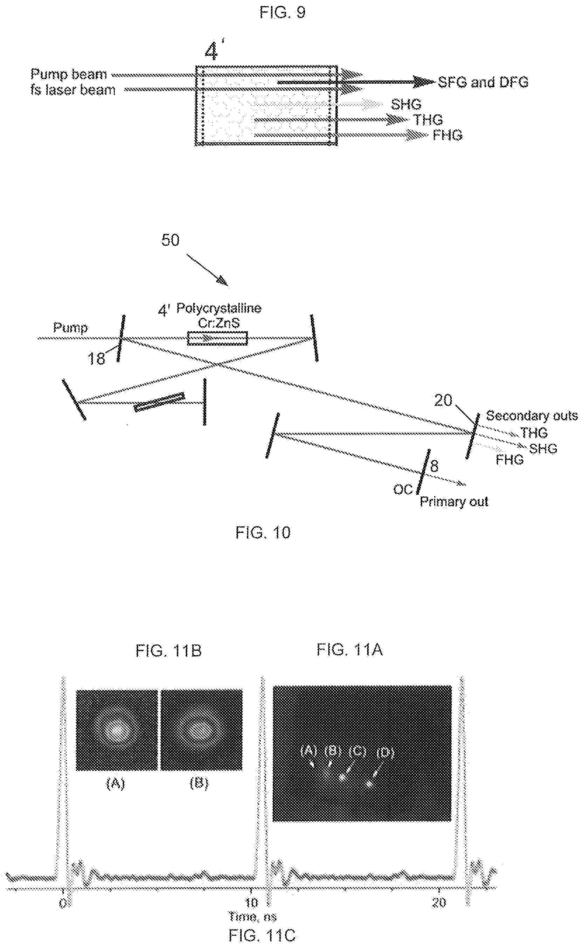

Referring specifically to FIGs. 9 and 10, KLM laser 50 is configured with polycrystalline TM:II-VI gain medium 4'. The disclosed configuration of FIG. 10 is operative to simultaneously output the beams at respective second, third and fourth harmonic generation wavelengths shown respectively in yellow (SHG), green (THG) and blue(FHG) in FIG. 9, as well as sum- and difference-frequency wavelengths both shown in black (SFG and DFG).

The laser output at a fundamental wavelength is implemented via partially transmitting OC 8. The laser outputs at respective second, third, and forth harmonics leave the resonator via mirror 20 after reflection at mirror 18. It is important to point out that all of the resonator's mirrors do not have to be specially designed to generate a high harmonic output. In the tested device, the mirrors transmission in SHG wavelengths range is about 50% and oscillates as a function of the wavelength. FIG. 11A illustrates snapshot of typical images of the outputs of 2 W KLM laser 50 at respective fundamental (A), second (B), third (C) and forth (D) harmonic wavelengths (2300, 1150, 770, 575 nm respectively) obtained by an IR sensitive card after placed behind mirror 20. FIG. 11B illustrates two images of the output beam at the fundamental frequency and second harmonic measured by pyrocamera placed behind the OC 8. FIG. 11C illustrates a graph related to a waveform of the KLM laser pulse train which is acquired at the SHG wavelength. Thus, a considerable fraction (up to 50 %) of the mid-IR femtosecond laser emission is converted to the second harmonic and the amount of the SH power can be adjusted by control of the OC reflectivity.

The output power of fs laser 50 of FIG. 10 at SHG wavelength was 30 mW after mirror 20. That allows obtaining 240 mW SHG power inside the resonator (one has to take into account 50% transmission of the mirrors 18, 20 and the fact that SHG occurs in two opposite directions). The obtained results reveal the following properties of polycrystalline TM:II-VI materials: Polycrystalline TM:II-VI materials are rather efficient nonlinear frequency converters of mid-IR fs pulses (e.g. approximately the same optical power at fundamental and at SHG wavelengths has been obtained during the proof-of-principle experiment). The phase-matching bandwidth of polycrystalline TM:II-VI materials is broad enough to allow for SHG of the whole fs laser emission spectrum. The phase-matching bandwidth of polycrystalline TM:II-VI materials is broad enough to allow for simultaneous SHG, THG, and FHG. Polycrystalline TM:II-VI materials inside the disclosed planar resonator can function as the fs laser gain medium as well as the nonlinear frequency converter. Thus the laser 50 may output multiple fs outputs at four different wavelengths due to the polycrystalline structure of gain medium 4' when the sizes of the microscopic single-crystal grains are of the order of the coherence length of SHG, THG and FHG processes.

Dissimilarities in the grain size and in orientation of the crystallographic axes result in the 'patterning' of the material, like in quasi phase matched (QPM) nonlinear converters. Unlike in the standard QPM material, the patterning is not regular but random. On the one hand, the nonlinear gain in randomly patterned material is very low. On the other hand, random patterning results in very large bandwidth of the nonlinear frequency conversion. Accordingly, low nonlinear gain of polycrystalline Cr²⁺:ZnS is compensated by a high peak intensity of fs laser pulses inside the resonator. In summary, the use of polycrystalline TM:II-VI materials with randomized QPM has following important features:
(i) The use of polycrystalline TM:II-VI materials allows for nonlinear frequency conversion of the whole emission spectrum of the fs laser due to very large nonlinear bandwidth of the medium.
(ii) The nonlinear frequency conversion in polycrystalline TM:II-VI materials may include SHG, sum frequency mixing between the laser emission at fundamental wavelength and its optical harmonics, sum and difference frequency mixing between the fs laser and other laser source (e.g. the pump laser), etc.
(iii) Mounting of the polycrystalline TM:II-VI material at normal incidence allows to reduce the laser beam size inside the medium and, hence, increase the optical intensity and, hence, significantly increase the nonlinear conversion efficiency.
(iv) Mounting of the polycrystalline TM:II-VI material inside the planar resonator of the fs laser allows for simultaneous generation of fs laser pulses at fundamental laser wavelength and at a number of secondary wavelengths (SHG, THG, FHG, SFG, DFG, etc.)
(v) Mounting of the polycrystalline TM:II-VI medium at normal incidence inside the planar resonator of the KLM laser allows to increase the length of the gain element and, hence, increase the length of nonlinear interaction and, hence, further significantly increase the nonlinear conversion efficiency.
(vi) Mounting of the polycrystalline TM:II-VI material inside the planar resonator of the KLM laser allows for precise control of fs laser parameters via the interplay between the Kerr nonlinearity and other nonlinearities in the material, as will be described below.
(vii) Mounting of the polycrystalline TM:II-VI material inside the planar resonator of the KLM laser allows to maximize the nonlinear conversion efficiency as the optical power, which circulates inside the resonator, is always higher than the optical power outside the resonator. Furthermore, the optical power inside the planar resonator (and hence, the intensity of the laser beam in polycrystalline TM:II-VI material) can be precisely controlled by optimization of the reflectivity of the output coupler.
(viii) The secondary output of polycrystalline TM:II-VI fs laser at SHG, THG, FHG, SFG, DFG wavelengths can be implemented via specially designed dichroic mirror with high reflectivity HR at fundamental laser wavelength and high transmission HT at secondary wavelengths.
(ix) The secondary output of polycrystalline TM:II-VI fs laser at SHG, THG, FHG, SFG, DFG wavelengths can be implemented via specially designed dielectric coated plates with HT at fundamental laser wavelength and HR at secondary wavelengths. The plates can be mounted e.g. between the polycrystalline TM:II-VI optical element and the resonator mirrors.

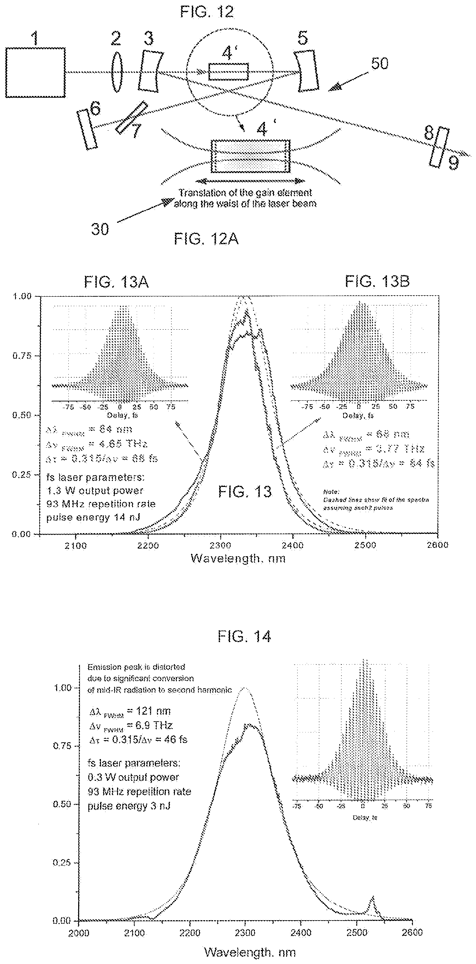

FIGs. 12 and 12A illustrate a schematic for controlling the parameters of polycrystalline TM:II-VI Kerr lens mode locked laser 50. Similar to the schematic of FIG. 4, the illustrated schematic is configured with optical pump source 1, pump beam focusing and shaping optics 2, folded concave dielectric coated mirror with high reflectivity at the laser wavelength and high transmission at pump wavelength 3, antireflection (AR) coated polycrystalline TM:II-VI gain element 4' mounted at normal incidence. The gain element 4' is mounted on a stage 30 of FIG. 12A, which allows for translation along the laser beam as shown by a two-arrow line. The KLM laser 50 further includes folded concave dielectric coated mirror with high reflectivity at laser wavelength (and optional high transmission at pump and/or SHG, THG, FHG, SFG, DFG wavelengths) 5. It also has a plane mirror 6 with high reflectivity at laser wavelength (dielectric or metal coated), optional polarization components and components for dispersion compensation, such as prism 7, configured as a plane parallel plate mounted in the laser resonator at Brewster's angle. The disclosed KLM laser further includes an output coupler 8 transmissive to output laser beam 9 at the fundamental wavelength, and secondary outputs 10 transmissive to SHG wave (and/or THG, FHG, SFG, DFG wavelengths). The path of the laser beam is shown by red color and the pump beam is shown by green color.

Kerr-lens mode locked lasers rely on the Kerr effect: a nonlinear optical effect occurring when intense light propagates in optical medium; it can be described as instantaneously occurring modification of the refractive index of the medium. The "strength" of the Kerr effect is proportional to the optical intensity: *S_{Kerr}* ∼ *I*. Therefore, the tight focusing of the laser beam in the gain medium is essential in KLM lasers. The required focusing is usually achieved by placing the gain medium between the two curved mirrors in the waist of the laser beam and by optimization of the distance between the curved mirrors. The waist of the laser beam is schematically shown in Fig. 12A. The optical intensity is proportional to the laser beam area and hence it reaches maximum in the waist and decreases with increase of the beam size.

The experiments show that polycrystalline TM:II-VI medium is suitable material for KLM lasers. The experiments also show that polycrystalline TM:II-VI medium is rather an efficient SHG converter for mid-IR fs pulses as disclosed above. The "strength" of the SHG effect is proportional to the optical intensity squared: *S_{SHG} ∼ I².*

Thus, two nonlinear effects simultaneously occur in polycrystalline TM:II-VI KLM laser: Kerr lensing (proportional to *I*) and SHG (proportional to *I²*). Different dependences of the Kerr lensing and of SHG on the optical intensity allows to vary the relative "strengths" of two nonlinear effects by translation of the polycrystalline TM:II-VI gain element along the waist of the laser beam. Thus, the nonlinear action of polycrystalline TM:II-VI medium can be redistributed between those two nonlinear effects in a controllable manner.

In particular, FIGs. 13, 13A and 13B illustrate the emission spectra, autocorrelation traces obtained for two locations (in red and blue) of gain medium 4' with respect to the curved mirrors 3 and 5 of FIG. 12. As can be seen, translation of the polycrystalline Cr:ZnS gain element resulted in significant variation of the fs laser parameters: pulse duration was reduced from 84 fs to 68 fs (the width of the emission spectrum has proportionally increased). Thus, proposed method allows for precise adjustment of fs laser parameters. Furthermore, translation of the polycrystalline Cr:ZnS gain element resulted in variation of fs laser output power at SHG wavelength (between ∼10 mW and ∼20 mW). The increase of the SHG output is exhibited by a distortion of the laser emission spectrum at fundamental wavelength (high SHG output corresponds to the flat-top emission peak as a significant fraction of the laser emission is converted to SHG). Referring to FIG. 14, the ability for precise control of the polycrystalline TM:II-VI KLM laser parameters results a 46 fs pulse duration, which as mentioned before has never been obtained in the prior art related to mid-IR TM:II-VI KLM lasers.

The simultaneous presence of the Kerr effect and of strong enough SHG effect in the polycrystalline TM:II-VI materials has following important applications:
(i) Translation of the polycrystalline TM:II-VI gain element, which is mounted inside the planar resonator of the KLM laser, along the waist of the laser beam allows for precise redistribution of the fs laser power between the primary output at fundamental wavelength and secondary output at SHG, THG, FHG, SFG, DFG wavelengths.
(ii) Translation of the polycrystalline TM:II-VI gain element, which is mounted inside the planar resonator of the KLM laser, along the waist of the laser beam allows for precise control of fs laser parameters (pulse duration, width and shape of the emission spectrum).
(iii) Simultaneous presence of the Kerr effect and of strong enough SHG effect in the polycrystalline TM:II-VI materials enables generation of shorter laser pulses (if compared with conventional Kerr-lens mode locked regime).

## Claims

1. A Kerr Mode Locked, KLM, laser comprising:
a resonant cavity; and
a gain medium (4') selected from polycrystalline transition metal doped II-VI materials, TM: II-VI, the gain medium (4') being mounted at a normal angle of incidence to a pump beam and mounted in the resonant cavity so as to induce Kerr-lens mode locking sufficient for the resonant cavity to emit a pulsed laser beam (9) at a fundamental wavelength, wherein pulses of the emitted laser beam (9) at the fundamental wavelength each vary, meaning fall, within a 1.8 - 8 µm wavelength range, have a pulse duration equal to or longer than 30 - 35 fs time range and an average output power within a mW to about 20 W power range, a linearly polarized fiber laser pump source (1) selected from an erbium or thulium doped single mode fiber and operative to emit a pump beam which is coupled into the gain medium (4') at a pump wavelength different from the fundamental wavelength, wherein the laser and pump beams remain circular while propagating through the gain medium (4').

2. The KLM laser of claim 1, wherein the gain medium (4') is configured with a phase-matching bandwidth broad enough to provide for emitting the output laser beam (9) at half the fundamental wavelength within the entire fundamental wavelength range.

3. The KLM laser of claim 2, wherein the phase-matching bandwidth of the gain medium (4') is sufficiently broad for generating second, third and fourth harmonic wavelengths of the fundamental wavelength simultaneously with the latter.

4. The KLM laser according to any of claims 1 to 3, wherein the resonant cavity is planar and/or
wherein the gain medium (4') includes TM doped binary and ternary II-VI materials.

5. The KLM laser according to any of claims 1 to 4, wherein the gain medium (4') includes TM doped binary and ternary II-V1 materials and wherein the materials include Cr2+:ZnSe, Cr2+:ZnS, Cr2+:CdSe, Cr2+:CdS, Cr2+:ZnTe, Cr2+:CdMnTe, Cr2+:CdZnTe, Cr2+:ZnSSe, Fe2+:ZnSe, Fe2+:ZnS, Fe2+:CdSe, Fe2+:CdS, Fe2+:ZnTe, Fe2+:CdMnTe, Fe2+:CdZnTe, Fe2+:ZnSSe.

6. The KLM laser according to any of claim 1 to 5, wherein the gain medium (4') is configured to uniformly release heat in response to the coupled pump beam which generates various uniform, axially symmetric thermal-optical effects inside the pumped gain medium (4').

7. The KLM laser of claim 2 or 3, wherein the phase-matching bandwidth of the gain medium (4') is sufficiently broad for generating the output laser beam at a sum of the pump and fundamental wavelengths and a difference therebetween, and a sum of fundamental and second, third and fourth optical harmonic wavelengths.

8. The KLM laser according to any of claims 1 to 7, wherein the resonant cavity includes at least two adjacent upstream and downstream dielectrically coated folded mirrors (3, 5) spaced apart along a path of the pump beam and each configured with a high reflectivity at the fundamental wavelength and high transmission at the pump wavelength, the gain medium (4') being located between and spaced from the folded mirrors (3, 5), the downstream folded mirror (5) being configured to at least partially transmit a high harmonic wavelength.

9. The KLM laser according to any of claims 1 to 8, wherein the resonant cavity further includes a partially transmitting at a fundamental wavelength output coupler (8), and at least one plane dichroic mirror (6) upstream from the output coupler (8) and configured with the high reflectivity at the fundamental wavelength, and at least one intermediary plate (12) with high transmission at the fundamental and high harmonic wavelength
and/or
wherein the resonant cavity further includes a dispersion compensation element (7) configured as a plane parallel plate or prism and operative to limit a dispersion, which is mounted at a Brewster angle

10. The KLM laser according to any of claims 1 to 9, wherein the resonant cavity further includes a Brewster mounted birefringent tuner (11).

11. The KLM laser according to any of claims 1 to 10 further comprising a translation stage (30) displacing the gain medium (4') within the resonant cavity along a waist of the laser beam to controllably redistribute the average power of the laser beam among a primary output of the emitted laser beam at the fundamental wavelength and secondary outputs at respective second, third and fourth harmonic wavelengths.

12. A method of femtosecond laser emission in a Kerr lens-mode locked, KLM, laser, comprising:
providing a resonant cavity; and
mounting a gain medium (4') selected from transition metal doped II-VI, TM:II-VI, materials at a normal incidence angle to a pump beam, within the resonant cavity, thereby Kerr-lens mode locking the resonant cavity so as to emit a primary output of the laser emission including a train of output pulses at a fundamental wavelength, wherein the pulses each vary, meaning fall, within a 1.8 - 8 µm wavelength range, have a pulse duration equal to or longer than 30 - 35 fs time range and an average output power within a mW to about 20 W power range, selecting a linearly polarized fiber laser pump source (1) from an erbium or thulium doped single mode fiber and operating the linearly polarized fiber laser pump source (1) to emit a pump beam which is coupled into the gain medium (4') at a pump wavelength different from the fundamental wavelength, wherein the laser and pump beams remain circular while propagating through the gain medium (4').

13. The method of claim 12 further comprising providing a secondary output of the laser beam at a second harmonic wavelength of the fundamental wavelength along the wavelength range simultaneously with the primary output.

14. The method of claim 12 or 13 further comprising providing additional outputs of the laser beam at third and fourth harmonic wavelengths of the fundamental wavelength simultaneously with the primary and secondary outputs.

15. The method according to any of claims 12 to 14 further comprising:
generating a pump beam at a pump wavelength different from the fundamental wavelength, and coupling the pump beam into the gain medium (4'), and
generating additional outputs of the laser beam at a sum of the pump and fundamental wavelengths and a difference therebetween, and a sum of fundamental and second, third and fourth optical harmonic wavelengths and a difference thereof.

## Patentansprüche

1. Kerr-modengekoppelter-Laser, KLM-Laser, der umfasst:
einen Hohlraumresonator; und
ein Verstärkungsmedium (4'), das aus mit einem polykristallinen Übergangsmetall dotierten II-VI-Materialien, TM:II-VI, gewählt ist, wobei das Verstärkungsmedium (4') unter einem normalen Einfallswinkel zu einem Pumpstrahl angebracht ist und in dem Hohlraumresonator in der Weise angebracht ist, dass es eine Kerr-Linsen-Modenkopplung induziert, die ausreicht, damit der Hohlraumresonator einen gepulsten Laserstrahl (9) mit einer Grundwellenlänge emittiert, wobei die Impulse des emittierten Laserstrahls (9) jeweils mit der Grundwellenlänge variieren, d. h. innerhalb eines Wellenlängenbereichs von 1,8 - 8 µm liegen, eine Impulsdauer eines Zeitbereichs gleich oder größer 30 - 35 fs und eine durchschnittliche Ausgangsleistung innerhalb eines Leistungsbereichs von einem mW bis etwa 20 W aufweisen, eine linear polarisierte Faserlaserpumpquelle (1), die aus einer Erbium- oder Thulium-dotierten Einmodenfaser gewählt ist und dafür betreibbar ist, einen Pumpstrahl zu emittieren, der bei einer anderen Pumpwellenlänge als der Grundwellenlänge in das Verstärkungsmedium (4') gekoppelt wird, wobei der Laser- und der Pumpstrahl kreisförmig bleiben, während sie sich durch das Verstärkungsmedium (4') fortpflanzen.

2. KLM-Laser nach Anspruch 1, wobei das Verstärkungsmedium (4') mit einer Phasenanpassungsbandbreite konfiguriert ist, die breit genug ist, um innerhalb des gesamten Grundwellenlängenbereichs das Emittieren des Ausgangslaserstrahls (9) mit der Hälfte der Grundwellenlänge sicherzustellen.

3. KLM-Laser nach Anspruch 2, wobei die Phasenanpassungsbandbreite des Verstärkungsmediums (4') ausreichend breit ist, um die Wellenlängen der zweiten, dritten und vierten Harmonischen der Grundwellenlänge gleichzeitig mit der Letzteren zu erzeugen.

4. KLM-Laser nach einem der Ansprüche 1 bis 3, wobei der Hohlraumresonator planar ist und/oder wobei das Verstärkungsmedium (4') TM-dotierte binäre und ternäre II-VI-Materialien enthält.

5. KLM-Laser nach einem der Ansprüche 1 bis 4, wobei das Verstärkungsmedium (4') TM-dotierte binäre und ternäre II-VI-Materialien enthält und wobei die Materialien enthalten: Cr2+:ZnSe, Cr2+:ZnS, Cr2+:CdSe, Cr2+:CdS, Cr2+:ZnTe, Cr2+:CdMnTe, Cr2+:CdZnTe, Cr2+:ZnSSe, Fe2+:ZnSe, Fe2+:ZnS, Fe2+:CdSe, Fe2+:CdS, Fe2+:ZnTe, Fe2+:CdMnTe, Fe2+:CdZnTe, Fe2+:ZnSSe.

6. KLM-Laser nach einem der Ansprüche 1 bis 5, wobei das Verstärkungsmedium (4') dafür konfiguriert ist, als Reaktion auf den gekoppelten Pumpstrahl gleichförmig Wärme freizusetzen, was innerhalb des gepumpten Verstärkungsmediums (4') verschiedene gleichförmige, axialsymmetrische thermisch-optische Effekte erzeugt.

7. KLM-Laser nach Anspruch 2 oder 3, wobei die Phasenanpassungsbandbreite des Verstärkungsmediums (4') ausreichend breit ist, um den Ausgangslaserstrahl bei einer Summe der Pump- und der Grundwellenlänge und bei einer Differenz dazwischen und bei einer Summe der Grundwellenlänge und der Wellenlängen der zweiten, dritten und vierten optischen Harmonischen zu erzeugen.

8. KLM-Laser nach einem der Ansprüche 1 bis 7, wobei der Hohlraumresonator wenigstens zwei angrenzende vorgeschaltete und nachgeschaltete dielektrisch beschichtete Knickspiegel (3, 5), die entlang eines Wegs des Pumpstrahls voneinander beabstandet sind und die jeweils bei der Grundwellenlänge mit einem hohen Reflexionsvermögen und bei der Pumpwellenlänge mit hoher Durchlässigkeit konfiguriert sind, enthält, wobei sich das Verstärkungsmedium (4') zwischen und beabstandet von den Knickspiegeln (3, 5) befindet, wobei der auslassseitige Knickspiegel (5) dafür konfiguriert ist, die Wellenlänge einer hohen Harmonischen wenigstens teilweise durchzulassen.

9. KLM-Laser nach einem der Ansprüche 1 bis 8, wobei der Hohlraumresonator ferner einen bei einer Grundwellenlänge teilweise durchlässigen Ausgangskoppler (8) und wenigstens einen ebenen dichroitischen Spiegel (6) einlassseitig von dem Ausgangskoppler (8) und der mit dem hohen Reflexionsvermögen bei der Grundwellenlänge konfiguriert ist, und wenigstens eine Zwischenplatte (12) mit hoher Durchlässigkeit bei der Grundwellenlänge und bei der Wellenlänge einer hohen Harmonischen enthält, und / oder
wobei der Hohlraumresonator ferner ein Dispersionskompensationselement (7), das als eine planparallele Platte oder als ein Prisma konfiguriert ist und dafür betreibbar ist, eine Dispersion zu begrenzen, das unter einem Brewster-Winkel angebracht ist, enthält.

10. KLM-Laser nach einem der Ansprüche 1 bis 9, wobei der Hohlraumresonator ferner einen unter einem Brewster-Winkel angebrachten doppelbrechenden Tuner (11) enthält.

11. KLM-Laser nach einem der Ansprüche 1 bis 10, der ferner eine Translationsstufe (30) umfasst, die das Verstärkungsmedium (4') innerhalb des Hohlraumresonators entlang einer Taille des Laserstrahls verlagert, um die durchschnittliche Leistung des Laserstrahls zwischen einer primären Ausgabe des emittierten Laserstrahls bei der Grundwellenlänge und sekundären Ausgaben jeweils bei den Wellenlängen der zweiten, dritten und vierten Harmonischen steuerbar umzuverteilen.

12. Verfahren für die Femtosekunden-Laseremission in einem Kerr-Linsen-modengekoppelten Laser, KLM-Laser, wobei das Verfahren umfasst:
Bereitstellen eines Hohlraumresonators; und
Anbringen eines Verstärkungsmediums (4'), das aus mit einem Übergangsmetall dotierten II-VI-Materialien, TM:II-VI-Materialien, gewählt ist, unter einem normalen Einfallswinkel zu einem Pumpstrahl in dem Hohlraumresonator, dadurch Kerr-Linsen-Modenkoppeln des Hohlraumresonators, um eine primäre Ausgabe der Laseremission zu emittieren, die eine Folge von Ausgangsimpulsen mit einer Grundwellenlänge enthält, wobei die Impulse jeweils variieren, d. h. in einem Wellenlängenbereich von 1,8 - 8 µm liegen, eine Impulsdauer gleich oder größer einem Zeitbereich von 30 - 35 fs und eine durchschnittliche Ausgangsleistung in einem Leistungsbereich von einem mW bis etwa 20 W aufweisen,
Auswählen einer linear polarisierten Faserlaserpumpquelle (1) aus einer Erbium- oder Thulium-dotierten Einmodenfaser und Betreiben der linear polarisierten Faserlaserpumpquelle (1) zum Emittieren eines Pumpstrahls, der bei einer von der Grundwellenlänge verschiedenen Pumpwellenlänge in das Verstärkungsmedium (4') gekoppelt wird, wobei der Laser- und der Pumpstrahl kreisförmig bleiben, während sie sich durch das Verstärkungsmedium (4') fortpflanzen.

13. Verfahren nach Anspruch 12, das ferner das Bereitstellen einer zweiten Ausgabe des Laserstrahls mit der Wellenlänge einer zweiten Harmonischen der Grundwellenlänge entlang des Wellenlängenbereichs gleichzeitig mit der primären Ausgabe umfasst.

14. Verfahren nach Anspruch 12 oder 13, das ferner das Bereitstellen zusätzlicher Ausgaben des Laserstrahls bei den Wellenlängen der dritten und vierten Harmonischen der Grundwellenlänge gleichzeitig mit der primären und der sekundären Ausgabe umfasst.

15. Verfahren nach einem der Ansprüche 12 bis 14, das ferner umfasst:
Erzeugen eines Pumpstrahls bei einer von der Grundwellenlänge verschiedenen Pumpwellenlänge und
Koppeln des Pumpstrahls in das Verstärkungsmedium (4'), und Erzeugen zusätzlicher Ausgaben des Laserstrahls bei einer Summe der Pump- und der Grundwellenlänge und einer Differenz dazwischen und bei einer Summe der Grundwellenlänge und der Wellenlängen der zweiten, dritten und vierten optischen Harmonischen und einer Differenz davon.

## Revendications

1. Laser à blocage de modes par effet Kerr, KLM,
comprenant :
une cavité résonante ; et
un milieu de gain (4') sélectionné parmi des matériaux II-VI dopés par un métal de transition polycristallin, TM : II-VI, le milieu de gain (4') étant monté à un angle d'incidence normal à un faisceau de pompe et monté dans la cavité résonante de manière à induire un blocage de modes par lentille de Kerr suffisant pour que la cavité résonante émette un faisceau laser à impulsions (9) à une longueur d'onde fondamentale, dans lequel des impulsions du faisceau laser émis (9) à la longueur d'onde fondamentale varient chacune, c'est-à-dire tombent, au sein d'une plage de longueurs d'onde de 1,8 à 8 µm, ont une durée d'impulsion supérieure ou égale à une plage de temps de 30 à 35 fs et une puissance émise moyenne au sein d'une gamme de puissance du mW à environ 20 W, une source de pompe laser à fibre polarisée linéairement (1) sélectionnée parmi une fibre monomodale dopée à l'erbium ou au thulium et opérationnelle pour émettre un faisceau de pompe qui est couplé dans le milieu de gain (4') à une longueur d'onde de pompe différente de la longueur d'onde fondamentale, dans lequel les faisceaux laser et de pompe restent circulaires tout en se propageant à travers le milieu de gain (4').

2. Laser KLM selon la revendication 1, dans lequel le milieu de gain (4') est configuré avec une largeur de bande à synchronisme de phase suffisamment large pour fournir l'émission du faisceau laser de sortie (9) à la moitié de la longueur d'onde fondamentale au sein de la plage de longueurs d'onde fondamentales entière.

3. Laser KLM selon la revendication 2, dans lequel la largeur de bande à synchronisme de phase du milieu de gain (4') est suffisamment large pour générer des deuxième, troisième et quatrième longueurs d'onde harmoniques de la longueur d'onde fondamentale simultanément avec cette dernière.

4. Laser KLM selon l'une quelconque des revendications 1 à 3, dans lequel la cavité résonante est plane et/ou dans lequel le milieu de gain (4') inclut des matériaux II-VI binaires et ternaires dopés par un TM.

5. Laser KLM selon l'une quelconque des revendications 1 à 4, dans lequel le milieu de gain (4') inclut des matériaux II-VI binaires et ternaires dopés par un TM et dans lequel les matériaux incluent Cr2+/ZnSe, Cr2+/ZnS, Cr2+/CdSe, Cr2+/CdS, Cr2+/ZnTe, Cr2+/CdMnTe, Cr2+/CdZnTe, Cr2+/ZnSSe, Fe2+/ZnSe, Fe2+/ZnS, Fe2+/CdSe, Fe2+/CdS, Fe2+/ZnTe, Fe2+/CdMnTe, Fe2+/CdZnTe, Fe2+/ZnSSe.

6. Laser KLM selon l'une quelconque des revendications 1 à 5, dans lequel le milieu de gain (4') est configuré pour libérer de la chaleur uniformément en réponse au faisceau de pompe couplé qui génère divers effets thermiques-optiques uniformes à symétrie axiale à l'intérieur du milieu de gain pompé (4').

7. Laser KLM selon la revendication 2 ou 3, dans lequel la largeur de bande à synchronisme de phase du milieu de gain (4') est suffisamment large pour générer le faisceau laser de sortie à une somme des longueurs d'onde de pompe et fondamentale et une différence entre elles, et une somme de longueur d'onde fondamentale et de deuxième, troisième et quatrième longueurs d'onde harmoniques optiques.

8. Laser KLM selon l'une quelconque des revendications 1 à 7, dans lequel la cavité résonante inclut au moins deux miroirs pliés à revêtement diélectrique amont et aval adjacents (3, 5) espacés le long d'un trajet du faisceau de pompe et configurés chacun avec une haute réflectivité à la longueur d'onde fondamentale et une transmission élevée à la longueur d'onde de pompe, le milieu de gain (4') étant situé entre et espacé des miroirs pliés (3, 5), le miroir plié aval (5) étant configuré pour transmettre au moins partiellement une longueur d'onde harmonique élevée.

9. Laser KLM selon l'une quelconque des revendications 1 à 8, dans lequel la cavité résonante inclut en outre un coupleur de sortie (8) transmettant partiellement à une longueur d'onde fondamentale, et au moins un miroir dichroïque plan (6) en amont du coupleur de sortie (8) et configuré avec la haute réflectivité à la longueur d'onde fondamentale, et au moins une plaque intermédiaire (12) avec une transmission élevée à la longueur d'onde fondamentale et harmonique élevée et/ou
dans lequel la cavité résonante inclut en outre un élément de compensation de dispersion (7) configuré en tant que plaque ou prisme parallélépipédique et opérationnel pour limiter une dispersion, qui est monté à un angle de Brewster.

10. Laser KLM selon l'une quelconque des revendications 1 à 9, dans lequel la cavité résonante inclut en outre un syntoniseur biréfringent à montage de Brewster (11).

11. Laser KLM selon l'une quelconque des revendications 1 à 10, comprenant en outre un étage de translation (30) déplaçant le milieu de gain (4') au sein de la cavité résonante le long d'une taille du faisceau laser pour redistribuer de manière à pouvoir être contrôlée la puissance moyenne du faisceau laser parmi une sortie primaire du faisceau laser émis à la longueur d'onde fondamentale et des sorties secondaires à des deuxième, troisième et quatrième longueurs d'onde harmoniques respectives.

12. Procédé d'émission laser femtoseconde dans un laser à blocage de modes par lentille de Kerr, KLM, comprenant :
fournir une cavité résonante ; et
monter un milieu de gain (4') sélectionné parmi des matériaux II-VI dopés par un métal de transition, TM : II-VI, à un angle d'incidence normal à un faisceau de pompe, au sein de la cavité résonante, réalisant de ce fait un blocage de modes par lentille de Kerr de la cavité résonante de manière à émettre une sortie primaire de l'émission laser incluant un train d'impulsions de sortie à une longueur d'onde fondamentale, dans lequel les impulsions varient chacune, c'est-à-dire tombent, au sein d'une plage de longueurs d'onde de 1,8 à 8 µm, ont une durée d'impulsion supérieure ou égale à une plage de temps de 30 à 35 fs et une puissance émise moyenne au sein d'une gamme de puissance du mW à environ 20 W,
sélectionner une source de pompe laser à fibre polarisée linéairement (1) parmi une fibre monomodale dopée à l'erbium ou au thulium et opérant la source de pompe laser à fibre polarisée linéairement (1) pour émettre un faisceau de pompe qui est couplé dans le milieu de gain (4') à une longueur d'onde de pompe différente de la longueur d'onde fondamentale, dans lequel les faisceaux laser et de pompe restent circulaires tout en se propageant à travers le milieu de gain (4').

13. Procédé selon la revendication 12, comprenant en outre fournir une sortie secondaire du faisceau laser à une deuxième longueur d'onde harmonique de la longueur d'onde fondamentale le long de la plage de longueurs d'onde simultanément avec la sortie primaire.

14. Procédé selon la revendication 12 ou 13, comprenant en outre fournir des sorties supplémentaires du faisceau laser à des troisième et quatrième longueurs d'onde harmoniques de la longueur d'onde fondamentale simultanément avec les sorties primaire et secondaire.

15. Procédé selon l'une quelconque des revendications 12 à 14, comprenant en outre :
générer un faisceau de pompe à une longueur d'onde de pompe différente de la longueur d'onde fondamentale, et coupler le faisceau de pompe dans le milieu de gain (4'), et
générer des sorties supplémentaires du faisceau laser à une somme des longueurs d'onde de pompe et fondamentale et une différence entre elles, et une somme de longueur d'onde fondamentale et de deuxième, troisième et quatrième longueurs d'onde harmoniques optiques et une différence de celles-ci.
